# EUROPÄISCHE PATENTSCHRIFT

(11) **EP 1 716 730 B1**
(45) Veröffentlichungstag und Bekanntmachung des Hinweises auf die Patenterteilung: **17.03.2010**
(21) Anmeldenummer: 05700523.3
(22) Anmeldetag: 07.01.2005
(51) Int. Cl.: H05K 3/02

(54) **VERFAHREN ZUM PARTIELLEN LÖSEN EINER LEITFÄHIGEN SCHICHT**
METHOD FOR THE PARTIAL REMOVAL OF A CONDUCTIVE LAYER
PROCEDE POUR ENLEVER PARTIELLEMENT UNE COUCHE CONDUCTRICE

(30) Priorität: 09.02.2004 DE 102004006414
(43) Veröffentlichungstag der Anmeldung: 02.11.2006
(73) Patentinhaber: LPKF Laser & Elektronika d.o.o., 4208 Zgornje Jezersko (SI)
(72) Erfinder: PODOBNIK, Bostjan, 1000 Ljubljana (SI); KOVACIC, Drago, 9240 Ljutomer (SI); POPLASEN, Miran, 8000 Novo Mesto (SI)
(74) Vertreter: Scheffler, Jörg
(86) Internationale Anmeldenummer: PCT/DE2005/000010
(87) Internationale Veröffentlichungsnummer: WO 2005/076678

(56) Entgegenhaltungen:
- US-A- 5 494 781
- US-A- 5 525 205
- US-A1- 2001 006 766

## Beschreibung

Die Erfindung betrifft ein Verfahren zum partiellen Lösen einer definierten Fläche einer leitfähigen Schicht, insbesondere Kupferschicht, mittels eines Laserstrahls, bei dem die Laserstrahl-Parameter derart eingestellt werden, dass lediglich die leitfähige Schicht abgetragen wird, ohne dass dabei zugleich auch ein darunter liegendes, die leitfähige Schicht tragendes Substrat beeinträchtigt wird.

Ein solches Verfahren zum partiellen Lösen bzw. Abtragen einer leitfähigen Schicht von einem beispielsweise flexiblen oder polymeren Schaltungsträger, insbesondere auch dreidimensionalen Schaltungsträger oder von einer konventionellen Leiterplatte wird in der Praxis insbesondere dann eingesetzt, wenn ein chemisches Abtragen der gewünschten Fläche nicht möglich oder erwünscht ist, beispielsweise im Bereich der Prototypenfertigung.

Das Abtragen einer leitfähigen Schicht mittels Laserstrahlung ist dabei bereits grundsätzlich bekannt. Sofern die Materialeigenschaften des Substrates gegenüber der leitfähigen Schicht insbesondere hinsichtlich der jeweils erforderlichen Laserablationsgrenzwerte oder auch der Schmelzpunkte höhere Grenzwerte aufweisen, können die Laserparameter derart eingestellt werden. Auf diese Weise wird dann lediglich die leitfähige Schicht durch den Laserstrahl entfernt, während das Substrat nicht beschädigt oder beeinträchtigt wird.

Als problematisch erweisen sich die bekannten Verfahren, wenn das Substrat eine geringere Ablationsschwelle als die leitfähige Schicht aufweist, weil dadurch insbesondere bei einem zu erzielenden flächigen Abtrag der leitfähigen Schicht die Gefahr einer unzulässigen Schädigung besteht. Die niedrige Abtragsschwelle des Substrats, und damit die Gefahr seiner unzulässigen Schädigung, begrenzt daher beim flächenhaften Abtrag den möglichen Energieeintrag durch den Laser derart, dass die leitfähige Schicht nicht vollständig verdampft wird, sondern teilweise nur geschmolzen und verdrängt wird. Insbesondere kommt es dadurch am Rand der jeweiligen Spur zu einer Anhäufung. In den Bereichen dieser Aufhäufungen reicht die Laserenergie für einen zuverlässigen Abtrag der leitfähigen Schicht nicht mehr aus. Eine Erhöhung der Laserenergie ist jedoch ausgeschlossen, weil anderenfalls in den Bereichen, in denen keine Aufhäufung der leitfähigen Schicht stattgefunden hat, eine unerwünschte Schädigung oder Zerstörung des Substrates unvermeidlich ist. Andere Verfahren zum partiellen Lösen einer leitfähigen schicht sind aus US-A-5 531 601 und US 2001/006766 bekannt.

Der Erfindung liegt die Aufgabe zugrunde, insbesondere auch bei niedrigeren Grenzwerten der relevanten Materialeigenschaften des Substrates gegenüber der leitfähigen Schicht einen zuverlässigen und schnellen flächigen Abtrag einer definierten Fläche der leitfähigen Schicht zu ermöglichen. Dabei soll eine Beeinträchtigung des Substrates weitgehend ausgeschlossen sein.

Diese Aufgabe wird erfindungsgemäß mit einem Verfahren gemäß den Merkmalen des Anspruchs 1 gelöst. Die Unteransprüche betreffen besonders zweckmäßige Weiterbildungen der Erfindung.

Erfindungsgemäß ist also bei dem Verfahren zum partiellen Abtragen einer definierten Fläche vorgesehen dass, diese Fläche durch Abtragen der leitfähigen Schicht in ihrem äußeren Randbereich gegenüber den angrenzenden Bereichen der leitfähigen Schicht insbesondere thermisch isoliert und anschließend die abzutragende Fläche durch den Laserstrahl erwärmt wird, bis die Adhäsion der leitfähigen Schicht auf dem Substrat wesentlich verringert ist, um die Fläche von dem Substrat zu lösen. Die Erfindung geht dabei von der Überlegung aus, dass der Laserenergieeintrag nicht unmittelbar zur Verdampfung der gesamten definierten Fläche der leitfähigen Schicht mittels des Lasers eingesetzt wird, sondern im Bereich dieser Fläche lediglich die Adhäsionsverbindung zu dem Substrat durch den Laserenergieeintrag verringert werden kann, bis sich die leitfähige Schicht von dem Substrat lösen lässt. Die Erwärmung ist hierzu auf die definierte Fläche zu beschränken. Daher wird zunächst am Umfang dieser Fläche mittels des Laserstrahls eine thermische Isolierung oder zumindest signifikante Reduzierung des Wärmeübergangs oder der Wärmeleitung gegenüber den benachbarten Bereichen der leitfähigen Schicht durch Einbringen einer linienförmigen Ausnehmung mittels des Laserstrahls erzeugt, die prozesstechnisch vergleichsweise einfach zu beherrschen ist. Der Abtrag der erwärmten Fläche erfolgt dann bei geringen Adhäsionskräften flächig unter dem Einfluss der Schwerkraft oder äußerer Krafteinwirkungen, wodurch das Substrat frei von direkten Lasereinwirkungen bleibt. Auf diese Weise können daher auch vergleichsweise große Flächen schnell und zuverlässig abgetragen werden. Das Verfahren eignet sich dabei gleichermaßen für flexible Schaltungsträger wie auch für dreidimensionale polymere Schaltungsträger sowie zur Ausbildung von partiellen elektromagnetischen Abschirmungen und von Antennen auf Kunststoffgehäusen.

Eine besonders vorteilhafte Ausgestaltung des erfindungsgemäßen Verfahrens wird dadurch erreicht, dass die Fläche zunächst in Bereiche unterteilt wird, die durch Abtragen der leitfähigen Schicht am Umfang mittels des Laserstrahls gegeneinander thermisch isoliert sind. Hierdurch kann die Fläche in einzelne Bereiche solcher Größe unterteilt werden, die hinsichtlich der Prozesssicherheit und der Prozessdauer optimiert ist.

Dabei werden nach einer besonders praxisgerechten Weiterbildung der Erfindung die Größe oder Geometrie der Bereiche durch die Materialeigenschaften der leitfähigen Schicht und des Substrates bestimmt. Hierzu werden mittels einer zu diesem Zweck bestimmten Steuereinheit alle zur Festlegung der Bereiche relevanten Parameter erfasst und daraus die optimale Größe und Geometrie der Bereiche sowie auch die Reihenfolge der zu bearbeitenden Bereiche bestimmt.

Die Bereiche könnten in kreisförmige, dreieckige oder rechteckige Bereiche unterteilt werden, um so Bereiche einheitlicher Größe zu ermöglichen. Besonders vorteilhaft ist jedoch eine Abwandlung, bei der die Fläche hinsichtlich eines großen Flächeninhaltes im Verhältnis zum Umfang optimiert wird, um so kompakte und einfach von dem Substrat lösbare Bereiche zu schaffen. Die Festlegung der Bereiche kann dabei auch aufgrund von Messwerten vorangegangener Prozesse erfolgen.

Besonders praxisnah ist der Einsatz des Verfahrens insbesondere auch dann, wenn die leitfähige Schicht eine Materialsstärke zwischen 100 nm und 105 µm, insbesondere 5 µm bis 60µm aufweist, wobei der Laserstrahl eines Festkörperlasers eingesetzt wird, der zu diesem Zweck eine Wellenlänge von 1064nm bei einer Leistung zwischen 5 und 50 Watt aufweisen kann.

Die Erwärmung der Fläche zur Überwindung der Adhäsionskräfte könnte auch durch einen separaten Laser oder eine andere Wärmequelle erfolgen. Besonders vorteilhaft ist es jedoch, wenn der Laserstrahl zwischen kontinuierlichem und gütegeschaltetem Betrieb umschaltbar ist, um so einerseits die Strukturierung zur thermischen Isolierung der Fläche bzw. der Bereiche und andererseits eine gleichmäßige Erwärmung zu ermöglichen.

Die Fläche könnte bei entsprechender Eignung der leitfähigen Schicht mittels magnetischer oder elektrostatischer Kräfte abgetragen werden. Besonders vorteilhaft ist hingegen eine Abwandlung, bei der die erwärmte Fläche mittels einer gezielten Druckluftzufuhr von dem Substrat getrennt wird, wobei ein gezielter Druckluftstrahl ein Abheben der leitfähigen Schicht beginnend vom Rand zur Mitte der Fläche ermöglicht.

Weiterhin ist es auch Erfolg versprechend, wenn die erwärmte Fläche durch Absaugen von dem Substrat getrennt wird. Dadurch wird verhindert, dass sich erwärmte, abgelöste Teile auf dem Substrat an anderer Stelle absetzen können und durch die in ihnen gespeicherte thermische Energie das Substrat an dieser Stelle so weit anschmelzen können, dass sie daran haften bleiben.

Insbesondere erweist es sich dabei als besonders günstig, wenn die leitfähige Schicht der gesamten Fläche oder des jeweiligen Bereichs als Ganzes von dem Substrat gelöst wird. Das Lösen oder Trennen der leitfähigen Schicht von dem Substrat erfolgt dabei in einem einzigen Arbeitsgang, so dass der Aufwand zur Durchführung des Verfahrens weiter reduziert werden kann.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer Prinzipskizze in
- Fig.1: eine Draufsicht auf eine Leiterplatte mit einer abzutragenden Fläche;
- Fig.2: eine geschnittene Seitenansicht der in Figur 1 gezeigten Leiterplatte mit darin eingebrachten Ausnehmungen;
- Fig.3: eine weitere geschnittene Seitenansicht der in Figur 1 gezeigten Leiterplatte mit einer bereits partiell abgetragenen Schicht.

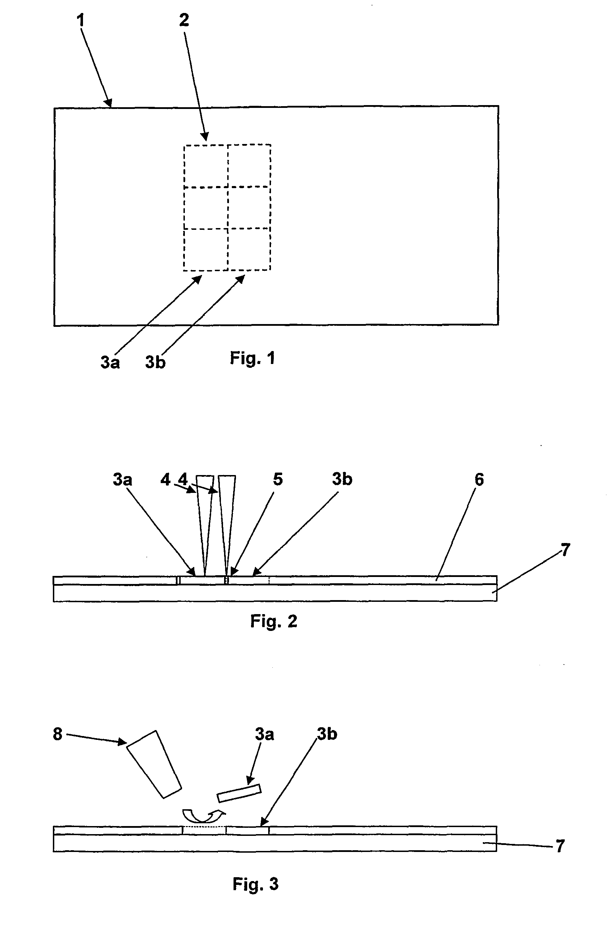

Figur 1 zeigt eine Draufsicht auf eine Leiterplatte 1 mit einer abzutragenden Fläche 2, die entsprechend der Materialeigenschaften der Leiterplatte 1 in Bereiche 3a, 3b gleicher Größe unterteilt ist. Zum partiellen Abtragen der definierten Fläche 2 mittels eines in Figur 2 dargestellten Laserstrahls 4 wird zunächst eine in Figur 2 gezeigte Ausnehmung 5 entlang eines jeweiligen Umfanges der Bereiche 3a, 3b eingebracht.

Wie in Figur 2 zu erkennen, wird der jeweilige Bereich 3a durch Abtragen einer leitfähigen Schicht 6 in ihrem äußeren Randbereich zunächst gegenüber den angrenzenden Bereichen 3b der leitfähigen Schicht 6 durch Einbringen einer Ausnehmung 5 thermisch isoliert, wobei eine Beeinträchtigung eines die leitfähige Schicht 6 tragenden Substrates 7 durch entsprechende Parametereinstellung des Laserstrahls 4 vermieden wird. Anschließend wird der abzutragende Bereich 3a durch den Laserstrahl 4 erwärmt, bis die Adhäsion der leitfähigen Schicht 6 auf dem Substrat 7 wesentlich verringert ist.

Mittels Druckluftzufuhr 8 kann der Bereich 3a anschließend von dem Substrat 7 problemlos gelöst werden, wie in Figur 3 dargestellt. Der Prozess wird wiederholt, bis alle Bereiche 3a, 3b der Fläche 2 entfernt sind.

## Patentansprüche

1. Verfahren zum partiellen Lösen einer definierten Fläche einer leitfähigen Schicht, insbesondere Kupferschicht, mittels eines Laserstrahls, bei dem die Laserstrahl-Parameter derart eingestellt werden, dass lediglich die leitfähige Schicht abgetragen wird, ohne dass dabei zugleich auch ein darunter liegendes, die leitfähige Schicht tragendes Substrat beeinträchtigt wird, wobei die Fläche durch Abtragen der leitfähigen Schicht in ihrem äußeren Randbereich gegenüber den angrenzenden Bereichen der leitfähigen Schicht isoliert wird, **dadurch gekennzeichnet, dass** die Fläche durch Einbringen einer linienförmigen Ausnehmung thermisch isoliert wird, wobei die Ausnehmung entlang eines jeweiligen Umfanges der Bereiche eingebracht wird, und anschließend die abzutragende Fläche erwärmt wird, bis die Adhäsion der leitfähigen Schicht auf dem Substrat wesentlich verringert ist, um die Fläche von dem Substrat zu lösen und der Abtrag der erwärmten Fläche dann bei geringen Adhäsionskräften flächig unter dem Einfluss der Schwerkraft oder äußerer Krafteinwirkungen erfolgt, wobei das Substrat frei von direkten Lasereinwirkungen bleibt.

2. Verfahren nach Anspruch 1, **dadurch gekennzeichnet, dass** die Fläche zunächst in Bereiche unterteilt wird, die durch Abtragen der leitfähigen Schicht am Umfang mittels des Laserstrahls gegeneinander thermisch isoliert sind.

3. Verfahren nach Anspruch 2, **dadurch gekennzeichnet, dass** die Größe und/oder Geometrie der Bereiche durch die Materialeigenschaften der leitfähigen Schicht und des Substrates bestimmt werden.

4. Verfahren nach zumindest Anspruch 2 oder 3, **dadurch gekennzeichnet, dass** die Fläche hinsichtlich eines großen Flächeninhaltes im Verhältnis zum Umfang optimiert wird.

5. Verfahren nach zumindest einem der vorhergehenden Ansprüche, **dadurch gekennzeichnet dass** die leitfähige Schicht eine Materialsstärke zwischen 100 nm und 105 µm, insbesondere 5 µm bis 60µm, aufweist.

6. Verfahren nach zumindest einem der vorhergehenden Ansprüche, **dadurch gekennzeichnet, dass** der Laserstrahl eines Festkörperlasers eingesetzt wird.

7. Verfahren nach zumindest einem der vorhergehenden Ansprüche, **dadurch gekennzeichnet, dass** der Laserstrahl zwischen kontinuierlichem und gütegeschalteten Betrieb umschaltbar ist.

8. Verfahren nach zumindest einem der vorhergehenden Ansprüche, **dadurch gekennzeichnet, dass** die erwärmte Fläche mittels einer gezielten Druckluftzufuhr von dem Substrat getrennt wird.

9. Verfahren nach zumindest einem Ansprüche 1 bis 7, **dadurch gekennzeichnet, dass** die erwärmte Fläche durch Absaugen von dem Substrat getrennt wird.

10. Verfahren nach zumindest einem der vorhergehenden Ansprüche, **dadurch gekennzeichnet, dass** die leitfähige Schicht der gesamten Fläche oder des jeweiligen Bereichs als Ganzes von dem Substrat gelöst wird.

## Claims

1. Method for the partial detachment of a defined surface of a conductive layer, in particular a copper layer, by means of a laser beam, in which the laser beam parameters are set in such a way that only the conductive layer is removed, without at the same time affecting a substrate that lies below and supports the conductive layer, the surface being insulated from the adjacent regions of the conductive layer by the removal of the conductive layer in its outer peripheral region, **characterized in that** the surface is thermally insulated by introducing a linear recess, the recess being introduced along a respective periphery of the regions, and the surface to be removed subsequently being heated until the adhesion of the conductive layer on the substrate is significantly reduced, in order to detach the surface from the substrate, and, when there are low forces of adhesion over the surface area, the removal of the heated surface then takes place under the influence of gravity or external force effects, the substrate remaining free from direct effects of the laser.

2. Method according to Claim 1, **characterized in that** the surface is first subdivided into regions which are thermally insulated from one another by removal of the conductive layer at the periphery by means of the laser beam.

3. Method according to Claim 2, **characterized in that** the size and/or geometry of the regions are determined by the material properties of the conductive layer and of the substrate.

4. Method according to at least Claim 2 or 3, **characterized in that** the surface is optimized with regard to a large area content in relation to the peripheral extent.

5. Method according to at least one of the preceding claims, **characterized in that** the conductive layer has a material thickness of between 100 nm and 105 µm, in particular 5 µm to 60 µm.

6. Method according to at least one of the preceding claims, **characterized in that** the laser beam of a solid-state laser is used.

7. Method according to at least one of the preceding claims, **characterized in that** the laser beam can be switched over between continuous operation and Q-switched operation.

8. Method according to at least one of the preceding claims, **characterized in that** the heated surface is separated from the substrate by means of a directed supply of compressed air.

9. Method according to at least one of Claims 1 to 7, **characterized in that** the heated surface is separated from the substrate by suction removal.

10. Method according to at least one of the preceding claims, **characterized in that** the conductive layer of the entire surface or of the respective region as a whole is detached from the substrate.

## Revendications

1. Procédé pour enlever une partie définie de la surface d'une couche conductrice, en particulier d'une couche de cuivre, au moyen d'un faisceau laser, dans lequel :
les paramètres du faisceau laser sont réglés de telle sorte que seule la couche conductrice soit enlevée, sans que le substrat sous-jacent qui porte la couche conductrice soit affecté,
la bordure extérieure de la surface étant isolée des parties adjacentes de la couche conductrice par enlèvement de la couche conductrice,
**caractérisé en ce que**
là surface est isolée thermiquement en réalisant une découpe linéaire
**en ce que** la découpe est réalisée le long du périmètre de chaque partie,
**en ce que** la surface à enlever est ensuite chauffée jusqu'à ce que l'adhérence de la couche conductrice sur le substrat ait nettement diminué pour détacher la surface par rapport au substrat,
**en ce que** lorsque les forces d'adhérence ont diminué, l'enlèvement de la surface chauffée s'effectue sous l'action de la gravité ou de l'action de forces extérieures et
**en ce que** le substrat n'est pas affecté par l'action directe du laser.

2. Procédé selon la revendication 1, **caractérisé en ce que** la surface est d'abord divisée en parties dont les bordures sont isolées thermiquement les unes des autres en enlevant la couche conductrice à l'aide du faisceau laser.

3. Procédé selon la revendication 2, **caractérisé en ce que** la taille et/ou la géométrie des parties sont déterminées par les propriétés des matériaux de la couche conductrice et du substrat.

4. Procédé selon au moins les revendications 2 ou 3, **caractérisé en ce que** le rapport entre l'aire et le périmètre de la surface est optimisé à une valeur élevée.

5. Procédé selon au moins l'une des revendications précédentes, **caractérisé en ce que** la couche conductrice a une épaisseur comprise entre 100 nm et 105 µm et en particulier entre 5 µm et 60 µm.

6. Procédé selon au moins l'une des revendications précédentes, **caractérisé en ce qu'**il utilise le faisceau laser d'un laser à corps solide.

7. Procédé selon au moins l'une des revendications précédentes, **caractérisé en ce que** le faisceau laser peut être commuté entre un fonctionnement continu et un fonctionnement pulsé.

8. Procédé selon au moins l'une des revendications précédentes, **caractérisé en ce que** la surface chauffée est séparée du substrat par apport contrôlé d'air sous pression.

9. Procédé selon au moins l'une des revendications 1 à 7, **caractérisé en ce que** la surface est séparée du substrat par aspiration.

10. Procédé selon au moins l'une des revendications précédentes, **caractérisé en ce que** toute la surface ou chaque partie de la surface de la couche conductrice sont séparées du substrat.
